# EUROPEAN PATENT SPECIFICATION

(11) **EP 4 545 500 B1**
(45) Date of publication and mention of the grant of the patent: **02.12.2026**
(21) Application number: 23851291.7
(22) Date of filing: 12.05.2023
(51) Int. Cl.: C03C 17/22, C03C 17/34

(54) **GLASS COVER PLATE AND PREPARATION METHOD THEREFOR, AND ELECTRONIC DEVICE**
GLASABDECKPLATTE UND HERSTELLUNGSVERFAHREN DAFÜR SOWIE ELEKTRONISCHE VORRICHTUNG
PLAQUE DE RECOUVREMENT EN VERRE ET SON PROCÉDÉ DE PRÉPARATION, ET DISPOSITIF ÉLECTRONIQUE

(30) Priority: 10.08.2022 CN 202210957004
(43) Date of publication of application: 30.04.2025
(73) Proprietor: Honor Device Co., Ltd., Shenzhen, Guangdong 518040 (CN)
(72) Inventor: MIAO, Dengkui, Shenzhen, Guangdong 518040 (CN); XU, Wenbin, Shenzhen, Guangdong 518040 (CN); GAO, Chengjie, Shenzhen, Guangdong 518040 (CN)
(74) Representative: Isarpatent
(86) International application number: PCT/CN2023/093750
(87) International publication number: WO 2024/032061

(56) References cited:
- WO-A1-2018/125676
- CN-A- 101 724 812
- CN-A- 101 724 812
- CN-A- 103 395 247
- CN-A- 103 613 282
- CN-A- 104 995 147
- CN-A- 107 140 840
- DE-A1- 102008 054 139
- JP-A- H0 667 019
- US-A- 4 599 272
- US-A- 5 772 862
- US-A1- 2020 331 801

## Description

This application claims priority to Chinese Patent Application No. 202210957004.3, filed with the China National Intellectual Property Administration on August 10, 2022 and entitled "GLASS COVER AND PREPARATION METHOD THEREFOR AND ELECTRONIC DEVICE".

### TECHNICAL FIELD

This application relates to the field of electronic device technologies, and in particular, to a glass cover and a preparation method therefor and an electronic device.

### BACKGROUND

A glass cover is usually disposed at the outermost of a glass display of an electronic device. In a process of using the glass cover of the electronic device, if no protective film is disposed, appearance defects such as scratches occur after long-term use. These defects destroy stress balance of the glass cover, resulting in a decrease in impact resistance of the glass cover.

In the conventional technology, a high-hardness optical film layer is usually disposed on an outer surface of a glass substrate through sputtering, to improve scratch resistance of the glass cover, see e.g. DE 10 2008 054139 A1, WO 2018/125676 A1, US 5 772 862 A, US 4 599 272 A, CN 101 724 812 A or US 2020/331801 A1. In a sputtering process, when a normal of a coating surface of the glass cover is parallel to an incident direction of a coating particle, a deposition speed is highest, and an optical film layer with uniform thickness may be obtained. However, when sputtering is performed on a 3D glass substrate with an arc-shaped edge, a specific angle α is formed between an arc surface normal and the incident direction of the coating particle, and a thickness of an optical film layer changes with α by cosα. In this case, it cannot be ensured that colors of a plane and an arc surface on the 3D glass substrate are kept consistent.

### SUMMARY

An objective of this application is to provide a glass cover and a preparation method therefor. A first material whose refractive index is greater than that of a glass substrate and a second material whose refractive index is less than that of the glass substrate are used, and the first material and the second material are atomic-level mixed to form an optical film layer. A refractive index of the obtained optical film layer is close to that of the glass substrate, and does not affect transmittance and reflectivity of the glass substrate, and the refractive index of the optical film layer does not change with a thickness of the optical film layer. When the optical film layer is formed on a glass substrate with an arc-shaped edge, no color difference in appearance of the glass substrate is caused due to a change in the thickness of the optical film layer. In addition, when the optical film layer falls off, appearance of the glass cover does not change. To achieve the foregoing objective, the following technical solutions are used in this application:

According to a first aspect of this invention, a glass cover according to claim 1 is provided. The glass cover includes a glass substrate and an optical film layer located on a surface of the glass substrate, and a refractive index of the optical film layer is 1.46-1.62. The optical film layer includes a first material and a second material that are atomic-level mixed, a mass ratio of the first material to the second material is (1~8):1, a refractive index of the first material> 1.6, and a refractive index of the second material< 1.52.

The optical film layer is formed on an outer surface of the glass substrate, to avoid a case in which beauty of the glass substrate is affected because the glass substrate is scratched or broken in a use process. In the foregoing solution, the first material whose refractive index is greater than that of the glass substrate and the second material whose refractive index is less than that of the glass substrate are atomic-level mixed to form the optical film layer. The refractive index of the formed optical film layer is close to that of the glass substrate, and a change in a thickness of the optical film layer does not affect the refractive index of the optical film layer. Therefore, when the optical film layer is formed on a glass substrate with an arc-shaped edge, for example, a 2.5D glass substrate or a 3D glass substrate, no color difference of the glass cover is caused due to a difference between a thickness at a bent part and a thickness at a base part in a coating process. The optical film layer in this application has scratch resistance performance, and improves beauty of an electronic device that uses the glass cover.

The first material includes at least one of Si₃N₄, Al₂O₃, AlN, ZrO₂, Nb₂O₅, Ta₂O₅, TiO₂, and the like.

In the foregoing solution, the first material is a material whose refractive index is greater than that of the glass substrate. The refractive index of the first material or the glass substrate refers to a ratio of a propagation speed of light in a vacuum to a propagation speed of the light in the first material or the glass substrate. A higher refractive index of the first material or the glass substrate indicates a stronger capability of refracting incident light. Therefore, the first material with a high refractive index and the second material with a low refractive index are mixed, to obtain the optical film layer whose refractive index is close to that of the glass substrate.

In a feasible implementation, Vickers hardness of the first material≥1000 HV.

When the optical film layer is disposed on the outer surface of the glass substrate, in addition to considering the refractive index of the optical film layer, the optical film layer needs to have specific hardness. When the hardness of the optical film layer is relatively low, in a process of using the electronic device, the film layer is prone to be scratched, and consequently a service life of the optical film layer is shortened. Therefore, in the foregoing solution, the optical film layer is prepared by using the first material with high hardness, and the prepared optical film layer has high hardness, is not prone to defects such as scratches in a use process, and has a long service life.

The second material includes at least one of SiO₂, MgF₂, LaF₃, AlF₃, and the like.

In the foregoing solution, the second material is a material whose refractive index is less than that of the glass substrate. The refractive index of the second material or the glass substrate refers to a ratio of a propagation speed of light in a vacuum to a propagation speed of the light in the second material or the glass substrate. A lower refractive index of the second material or the glass substrate indicates a weaker capability of refracting incident light. Therefore, the first material with a high refractive index and the second material with a low refractive index are mixed, to obtain the optical film layer whose refractive index is close to that of the glass substrate.

In a feasible implementation, a thickness of the optical film layer is 500 nm~5000 nm.

In the foregoing solution, the refractive index of the optical film layer does not change with the thickness, that is, regardless of the thickness of the optical film layer, the refractive index is close to that of the glass substrate. However, in coating process, the thickness of the optical film layer still needs to be controlled. If the thickness of the optical film layer is excessively high, hardness is high, scratch resistance is strong, and production costs are increased. If the thickness of the optical film layer is excessively low, scratch resistance is decreased, and a service life is short. When the thickness of the optical film layer falls within the foregoing range, both characteristics of high hardness and good beauty are achieved.

In a feasible implementation, when testing is performed by using a Mohs hardness tester pen, Mohs hardness of the optical film layer≥7 under the action of a test force of 500 g.

In the foregoing solution, the Mohs hardness means that by using a scoring method, a pyramid-shaped diamond needle is used to scratch a surface of the tested optical film layer, a depth of a scratch is measured, and the depth of the scratch is the Mohs hardness. In this application, the optical film layer is prepared by using the first material with high hardness, so that the Mohs hardness of the optical film layer falls within the foregoing range, and the optical film layer has better scratch resistance.

In a feasible implementation, Vickers hardness of the optical film layer≥1000 HV under the action of a load force of 18 mN.

In the foregoing solution, the Vickers hardness means that a diamond regular pyramid indenter with an included angle of 136 degrees between opposite surfaces is pressed into a surface of the optical film layer under the action of a specified load F, the load is removed after being maintained for a fixed time, a diagonal length d of an indentation is measured, then an indentation surface area is calculated, and finally average pressure on the indentation surface area is obtained, and is a Vickers hardness value of the material. In this application, the optical film layer is prepared by using the first material with high hardness, so that the Vickers hardness of the optical film layer falls within the foregoing range, and the optical film layer has better pressure resistance.

In a feasible implementation, a friction coefficient of the optical film layer is 0.01-0.06.

The optical film layer is disposed on a side that is of the glass substrate and that is away from another part of the electronic device. In a process of using the electronic device, an outer surface of the optical film layer is in contact with a finger of a user. If the friction coefficient of the optical film layer is excessively large, experience is prone to be degraded when the user frequently performs an operation on the electronic device. If the friction coefficient is excessively small, the electronic device is prone to receive an action instruction when the user unintentionally performs an operation. In the foregoing solution, the friction coefficient of the optical film layer is controlled within this range, so that the optical film layer is smooth and enables the electronic device to receive a correct instruction.

In a feasible implementation, transmittance of the optical film layer for visible light whose wavelength falls within 380 nm~780 nm>90%.

In the foregoing solution, the transmittance refers to a percentage of light that passes. Higher transmittance indicates clearer display of the glass cover. The glass cover is mounted on the electronic device, and the optical film layer is disposed on a side that is of the glass cover and that is away from another part of the electronic device. When a display generates a display image, light of the display image passes through the glass cover and then is received by a user. If the transmittance of the optical film layer is excessively low, brightness of the electronic device is reduced, and user experience is degraded. The transmittance of the optical film layer falls within the foregoing range, and the display image observed by the user through the glass cover is clear.

In a feasible implementation, reflectivity of the optical film layer for visible light whose wavelength falls within 380 nm~780 nm<6%.

The reflectivity of the optical film layer refers to a degree to which the optical film layer reflects light. Lower reflectivity of the optical film layer indicates a smaller amount of light reflected by the optical film layer, so that when the electronic device is used, experience closer to that of using paper is achieved by the display, and a better human feeling is achieved. If the reflectivity of the optical film layer is excessively high, when the electronic device is used in a strong light environment, a viewing process of the electronic device is affected. The reflectivity of the optical film layer used in the foregoing solution falls within this range, and the user may have good viewing or reading experience on the electronic device.

In a feasible implementation, the glass cover further includes a protective layer, and the protective layer is disposed on a side that is of the optical film layer and that is away from the glass substrate.

In the foregoing solution, the side that is of the optical film layer and that is away from the glass substrate is a touch surface of the user. In a use process of the user, a fingerprint or dirt is prone to be left at the optical film layer, and light transmittance and beauty of the optical film layer are affected. Therefore, the protective layer is disposed on the side that is of the optical film layer and that is away from the glass substrate, to further enhance a service life of the optical film layer while improving user experience.

In a feasible implementation, the glass substrate includes one of a 2D glass substrate, a 2.5D glass substrate, and a 3D glass substrate.

In the foregoing solution, a 2D glass cover is a flat glass cover; a 2.5D glass cover means that on the basis that entire glass is located on a same plane, a relatively obvious arc-shaped transition is formed around the glass cover by using a numerical control machine tool processing technology; and 3D glass means that a 3D curved surface is formed on a glass edge by using a hot bending mold, to present visual and experiential roundness. A 3D front cover includes a single-curved 3D front cover, a micro-double-curved 3D front cover, and a double-curved 3D front cover. For a single-curved 3D glass cover, only left and right side edges are hot bent into a curved surface shape. For a double-curved 3D glass cover, four edges are hot bent into a curved surface shape. For a micro-double-curved 3D glass cover, angles and depths of upper and lower edges are reduced on the basis of the double-curved 3D glass cover, to form a micro curved light and shadow effect on upper and lower sides. The refractive index of the optical film layer used in this application is close to that of the glass substrate, and no color difference in appearance of the glass substrate is caused due to a change in the thickness of the optical film layer. Therefore, when the optical film layer is formed on the 2D glass substrate, the 2.5D glass substrate, or the 3D glass substrate, no color change is generated, to ensure beauty of the electronic device that uses the glass cover.

In a feasible implementation, the glass substrate is a 3D glass substrate, and the 3D glass substrate includes a base part, a side part, and a bent part that connects the base part and the side part; and
the optical film layer is formed on surfaces of the base part, the bent part, and the side part, and a thickness of the optical film layer on the surface of the bent part is different from a thickness of the optical film layer on the surface of the base part.

In the foregoing solution, the 3D glass substrate is used as a base of the glass cover, so that the electronic device can have good appearance, and blocking of a signal of a mobile phone can be avoided. In addition, the optical film layer whose refractive index does not change with the thickness is used on the 3D glass substrate. Although there are different thicknesses, refractive indexes at the base part, the side part, and the bent part are close to that of the glass, and no color difference in appearance is generated.

In a feasible implementation, in an (L*, a*, b*) colorimetric system, an a* value and a b* value of reflected light that can be reflected by the optical film layer are respectively -2-2 and -2-2; and/or an a* value and a b* value of transmitted light that can be transmitted by the optical film layer are respectively -2-2 and -2-2.

In the foregoing solution, L* represents lightness, ranges from 0 to, and indicates a color change from dark (black) to light (white); a* indicates red and green, has a value change from positive to negative, and indicates a color change from red (positive) to green (negative), a larger a value indicates a redder color, and a smaller a value indicates a greener color; and b* indicates yellow and blue, has a value change from positive to negative, and indicates a color change from yellow (positive) to blue (negative), a larger b value indicates a yellower color, and a smaller b value indicates a bluer color. The a* value and the b* value of each of the transmitted light and the reflected light of the optical film layer provided in this solution fall within this range, and the glass cover of the electronic device does not appear to have a rainbow edge.

According to a second aspect of this invention, a preparation method for a glass cover according to claim 7 is provided. The preparation method includes:
preprocessing a glass substrate;
sputtering an alloy target on the glass substrate in a vacuum environment, so that a composite film layer is formed on a surface of the glass substrate, where the alloy target includes two or more types of element atoms; and
injecting gas into the composite film layer, where gaseous atoms or gaseous ions formed through excitation of the gas react with the composite film layer, to obtain a glass cover with a surface on which an optical film layer is formed, and a refractive index of the optical film layer is 1.46-1.62.

According to a third aspect of this invention, an electronic device according to claim 8 is provided. The electronic device includes the glass cover according to any one of the implementations of the first aspect or the glass cover prepared according to the preparation method for a glass cover according to the second aspect.

### BRIEF DESCRIPTION OF DRAWINGS

To describe the technical solutions in embodiments of this application more clearly, the following briefly describes the accompanying drawings that need to be used in the embodiments. Clearly, the accompanying drawings in the following descriptions show merely some embodiments of this application.

FIG. 1 is a schematic diagram of a structure of a mobile phone according to an embodiment of this application;
FIG. 2 is an exploded view of a mobile phone according to an embodiment of this application;
FIG. 3A, FIG. 3B, FIG. 3C, and FIG. 3D are respectively schematic diagrams of cross sections of a 2D rear cover, a 2.5D rear cover, a 3D rear cover, and a 5D rear cover of a mobile phone according to an embodiment of this application;
FIG. 4 is an exploded view of another mobile phone according to an embodiment of this application;
FIG. 5A, FIG. 5B, and FIG. 5C are respectively schematic diagrams of cross sections of a 2D glass substrate, a 2.5D glass substrate, and a 3D glass substrate of a mobile phone according to an embodiment of this application; and
FIG. 6 is a flowchart of preparation of a glass cover according to an embodiment of this application.

### Reference numerals:

100: Mobile phone;
110: Housing; 111: Frame; 112: Rear cover; 1121: Texture diaphragm; 113: Mainboard; 114: Battery; 115: First middle frame; 116: First groove; 117: Second groove; 118: Second middle frame; and
120: Glass cover; 121: Glass substrate; 121a: Base part; 121b: Side part; 121c: Bent part.

### DESCRIPTION OF EMBODIMENTS

In descriptions of implementations of this application, it should be understood that an orientation or positional relationship indicated by terms "length", "thickness", "upper", "lower", "front", "rear", "left", "right", "top", "bottom", "inner", "outer", and the like is an orientation or positional relationship shown based on the accompanying drawings, is merely intended to facilitate description of the implementations of this application and simplify description, is not intended to indicate or imply that a specified apparatus or element needs to have a specific orientation or be constructed and operated in a specific orientation, and therefore cannot be understood as a limitation on the implementations of this application. In addition, the terms "first" and "second" are used for description only, and cannot be understood as an indication or implication of relative importance or implicit indication of a quantity of indicated technical features. Therefore, features limited by "first" and "second" may explicitly or implicitly include one or more such features. In the descriptions of the implementations of this application, unless otherwise specifically limited, "a plurality of" means two or more.

In the descriptions of the implementations of this application, it should be noted that unless otherwise specified and limited, the term "connection" should be understood in a broad sense, for example, may indicate a fixed connection, a detachable connection, an integral connection, a mechanical connection, an electrical connection, mutual communication, a direct connection, an indirect connection implemented through an intermediate medium, an internal connection between two elements, or an interaction relationship between two elements. Persons of ordinary skill in the art may understand specific meanings of the foregoing terms in the implementations of this application based on specific cases.

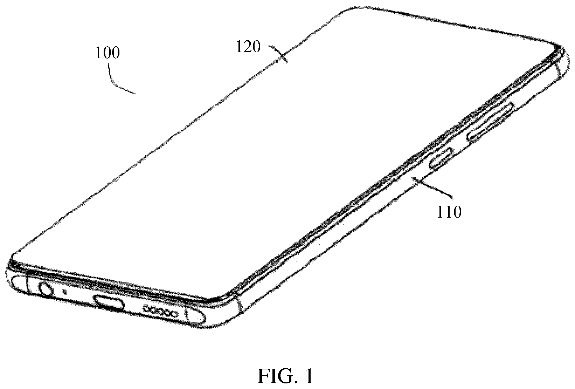

This application provides a glass cover. The glass cover may be applied to a front cover, a rear cover, or another part, for example, a camera cover, that is of an electronic device and whose scratch resistance needs to be improved. It should be noted that the electronic device to which the glass cover may be applied includes but is not limited to a mobile terminal such as a mobile phone, a tablet computer, a wearable device, a vehicle-mounted device, an augmented reality (augmented reality, AR)/virtual reality (virtual reality, VR) device, a notebook computer, an ultra-mobile personal computer (ultra-mobile personal computer, UMPC), a netbook, or a personal digital assistant (personal digital assistant, PDA), or may be a professional photographing device such as a digital camera, a digital single lens reflex/micro digital single lens reflex, an action camera, a pan-tilt-zoom camera, or an unmanned aerial vehicle. A specific type of the electronic device is not limited in embodiments of this application. The electronic device provided in this application uses a mobile phone 100 as an example. FIG. 1 is a schematic diagram of a structure of a mobile phone according to an embodiment of this application. As shown in FIG. 1, a housing assembly of the mobile phone 100 includes a housing 110 and a glass cover 120. The glass cover 120 is mounted on the housing 110.

Specifically, the housing 110 includes a frame 111 and a rear cover 112. The rear cover 112 and the glass cover 120 are respectively located on two sides of the frame 111, that is, the glass cover 120 and the rear cover 112 are disposed at an interval, and the frame 111 surrounds a periphery of the glass cover 120 and surrounds a periphery of the rear cover 112, so that an accommodation cavity is formed between the glass cover 120, the frame 111, and the rear cover 112. The accommodation cavity is used to place an electronic component such as a display, a mainboard 113, a battery 114, a processor, an external memory interface, an internal memory, a universal serial bus (universal serial bus, USB) interface, a charging management module, a power management module, a battery 114, an antenna, a mobile communication module, a wireless communication module, an audio module, a speaker, a receiver, a microphone, a headset jack, a sensor module, a button, a motor, an indicator, and a camera. In a disassembly process, if the housing 110 is separated from the glass cover 120, the electronic component located in the accommodation cavity may be observed.

In this application, the frame 111 and the rear cover 112 are respectively two parts of the housing 110, and the two parts are integrally formed and connected or detachably connected.

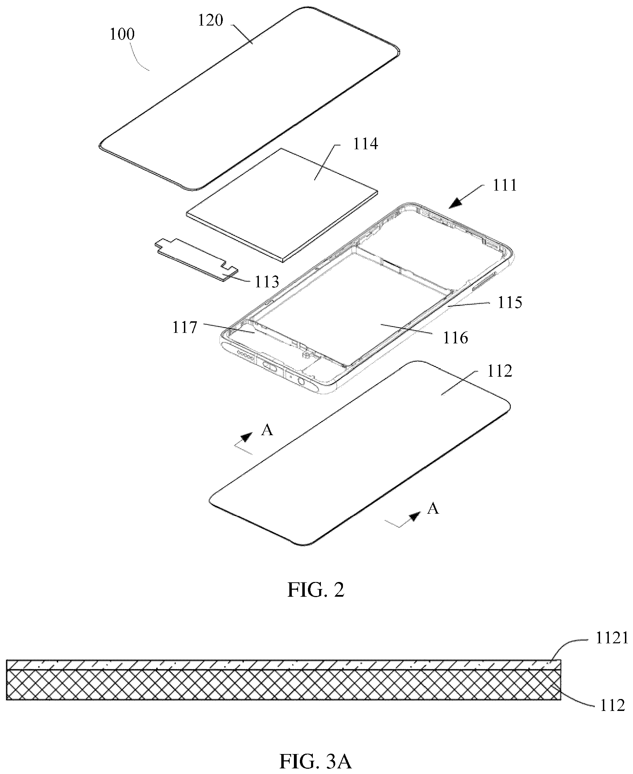

According to a first aspect, in an optional technical solution of this application, the frame 111 and the rear cover 112 may be two detachable parts, and the housing 110 of the mobile phone 100 may be formed by assembling the frame 111 and the rear cover 112 together. Specifically, FIG. 2 is an exploded view of a mobile phone according to an embodiment of this application. As shown in FIG. 2, the mobile phone 100 includes a glass cover 120, a rear cover 112, and a first middle frame 115. A periphery (which is briefly referred to as a first middle frame periphery below) of the first middle frame 115 may serve as a frame 111 of an electronic device. That is, the first middle frame periphery surrounds a periphery of the glass cover 120 and surrounds a periphery of the rear cover 112, and the rear cover 112 and the glass cover 120 are respectively located on two sides of the first middle frame 115. It may be learned that the rear cover 112 and the first middle frame 115 may be two different parts, and a housing 110 of the mobile phone 100 may be formed by assembling the rear cover 112 and the first middle frame 115 together. An assembly manner may be welding, slidable clamping performed by using a buckle, a fitting connection implemented by using a positioning pin and a positioning hole, or the like, or may be another connection manner. A connection manner of the rear cover 112 and the first middle frame 115 may be selected based on an actual requirement. This is not limited herein.

Further, the first middle frame 115 used in the foregoing solution may be disposed as a composite structure including a metal frame and a plastic frame. Specifically, the plastic frame may be continuously disposed along a peripheral edge of the metal frame, that is, the plastic frame is disposed on the entire peripheral edge of the metal frame. If disposal is performed in this manner, a structure is simple and costs are low. Alternatively, a plastic frame may be further disposed on a peripheral edge of the metal frame. Alternatively, the plastic frame and the metal frame are disposed at an interval in a circumferential direction, that is, the first middle frame 115 is mainly a metal frame, but the plastic frame is disposed at a position of a signal breakpoint. If disposal is performed in this manner, overall texture of the mobile phone 100 can be further improved, and user experience can be improved.

Compared with a solution in which the first middle frame 115 is disposed to be made of an all-plastic material or an all-metal material, the metal frame in the composite structure can reduce a thickness while ensuring overall structural strength, so that an overall thickness of the mobile phone 100 is reduced, to help meet a user requirement and improve user experience. The plastic frame in the composite structure is disposed to avoid interference caused by an all-metal frame to signal transmission or reception of the mobile phone 100. In addition, in an actual application process, the metal frame is not of a plate-like structure with a flat surface structure. A specific structure of the metal frame may be disposed based on an arrangement status of each electronic component in an accommodation cavity of the mobile phone 100. For example, the metal frame includes a plurality of grooves, for example, a first groove 116 and a second groove 117, configured to accommodate a battery 114 and a mainboard 113. The battery 114 may be disposed in the first groove 116, the mainboard 113 may be disposed in the second groove 117, and the battery 114 is electrically connected to the mainboard 113, so that the battery 114 can supply power to the mainboard 113. In addition to the first middle frame 115 of the composite structure including the metal frame and the plastic frame, there may further be a first middle frame 115 made of another material, for example, a first middle frame made of glass or a first middle frame made of ceramic. A material of the first middle frame 115 may be selected based on an actual requirement. This is not limited herein.

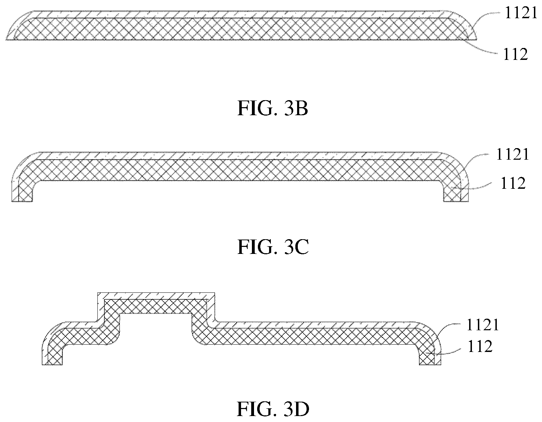

Further, FIG. 3A, FIG. 3B, FIG. 3C, and FIG. 3D are respectively schematic diagrams of cross sections of a 2D rear cover, a 2.5D rear cover, a 3D rear cover, and a 5D rear cover of a mobile phone according to an embodiment of this application. As shown in FIG. 3A, FIG. 3B, FIG. 3C, and FIG. 3D, the rear cover 112 used in the foregoing solution may be of a plate structure with a flat surface, that is, a 2D structure. In this case, the first middle frame 115 is also of a flat rectangular structure, and an edge of the rear cover 112 covers an edge of the first middle frame 115. Alternatively, the rear cover 112 may be a 2.5D rear cover. The 2.5D rear cover refers to a rear cover 112 on which an edge is an arc surface that is bent downward. The 2.5D rear cover has no protruding corner, and is not prone to be impacted by another object. Therefore, a probability that the housing 110 is damaged can be reduced, and an appearance surface of the housing 110 can be more visually appealing. The rear cover 112 may alternatively be a 3D rear cover. The 3D rear cover may also be referred to as a three-dimensional plate, and a surface of the 3D rear cover is in a three-dimensional shape. The rear cover 112 may alternatively be a 5D rear cover, that is, the cover is a 5D cover. The 5D cover may be adapted to, for example, a protruding structure of a camera, or certainly, there may be another protruding or recessed structure. A shape of the rear cover 112 may be selected based on an actual requirement. This is not limited herein.

A material of the rear cover 112 may be a metal material, a glass material, a plastic material, or a ceramic material, or there may be a rear cover 112 made of another composite material. The material of the rear cover 112 may be selected based on an actual requirement. This is not limited herein. Preferably, the material of the rear cover 112 used in this application is a glass fiber composite material, and the rear cover 112 is prepared by using the glass fiber composite material, so that the rear cover 112 can have relatively good mechanical strength and is light and thin. Specifically, the glass fiber composite material includes a glass fiber woven fabric and organic resin coating the glass fiber woven fabric. Glass fiber is an inorganic non-metal material, and has advantages such as good insulation, high heat resistance, good corrosion resistance, and high mechanical strength. The glass fiber composite material is formed by coating a glass fiber base material with organic resin, and the prepared rear cover 112 can have advantages such as fire retardancy, broken-resistance, corrosion resistance, high mechanical strength, lightness, and thinness.

In addition, to enable the rear cover 112 to have a better touch feeling, improve physical performance of the rear cover 112, and improve user experience, a texture diaphragm 1121 may be further disposed on an outer surface of the rear cover 112. The outer surface is a surface that is in direct contact with a finger of a user when the user touches the mobile phone 100. The outer surface of the rear cover 112 prepared by using the glass fiber composite material is a rough surface, to improve binding strength between the texture diaphragm 1121 and the rear cover 112. It may be understood that a cross section of the rough surface of the rear cover 112 may be of a concaveconvex structure, or may be an arc-shaped undulating cross section or of another cross-section structure, provided that the outer surface has specific roughness. The texture diaphragm 1121 is provided with a texture pattern and a color. The user may observe and touch the color and the texture pattern of the texture diaphragm 1121 on an outer surface of the cover. In some implementations, the texture pattern may be a texture effect such as a frosted pattern, a dot pattern, a diagonal, or a snowflake. This is not limited herein. There may be a plurality of texture diaphragms 1121, that is, the plurality of texture diaphragms 1121 are stacked and located on the outer surface of the rear cover 112. A texture microstructure of the texture pattern may be a U-shaped microstructure, a pyramid-shaped microstructure, a circular arc-shaped microstructure, a groove-shaped microstructure, or the like. This is not limited herein. By using the texture diaphragm 1121, visual beauty of the rear cover 112 can be improved, and the rear cover 112 can be broken-resistant, wear-resistant, light, and thin. The cover of the electronic device is formed by using a combination of the glass fiber composite material and the texture diaphragm 1121. Different texture and a more vivid appearance effect of the rear cover 112 can be provided in different combination manners of the glass fiber composite material and the texture diaphragm 1121.

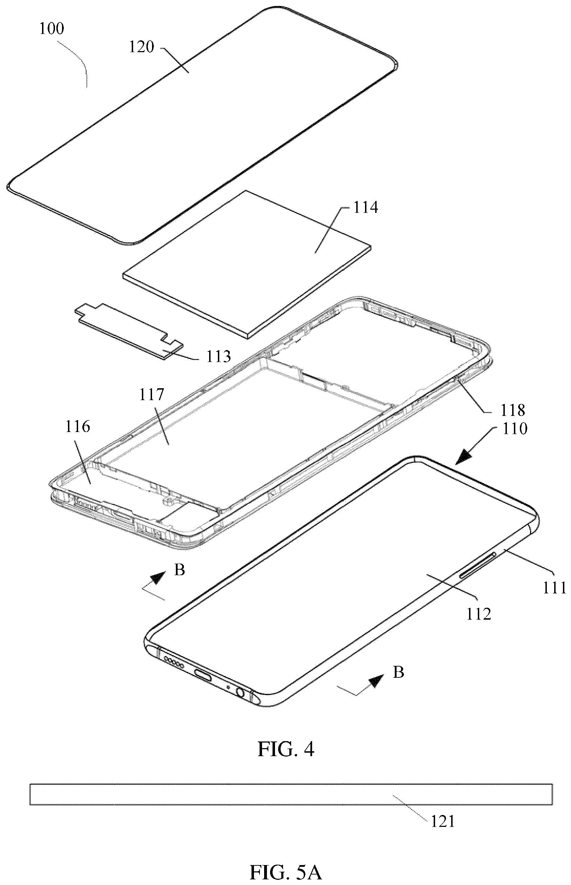

According to a second aspect, in another optional technical solution of this application, a difference from the first aspect is that a rear cover 112 and a frame 111 in this solution are two parts of an integrally formed structure, that is, a connection relationship between the rear cover 112 and the frame 111 cannot be split. Specifically, FIG. 4 is an exploded view of another mobile phone according to an embodiment of this application. As shown in FIG. 4, the mobile phone 100 includes a glass cover 120, a housing 110, and a second middle frame 118. The housing 110 includes a frame 111 and a rear cover 112. The frame 111 and the rear cover 112 are respectively two parts of the housing 110, the frame 111 and the rear cover 112 are integrally connected, and a connection relationship between the frame 111 and the rear cover 112 usually cannot be split. The second middle frame 118 is accommodated in an accommodation cavity between the glass cover 120, the frame 111, and the rear cover 112. It may be learned that in a use process, an edge of the glass cover 120 is directly connected to an edge of the frame 111 of the housing 110, and a middle frame used for locating an electronic component such as a mainboard 113 or a battery 114 is located between the glass cover 120 and the rear cover 112 of the housing 110. In addition to the foregoing special descriptions, a structure and a material of the second middle frame 118 or a material of the rear cover 112, and disposal of the texture diaphragm 1121 may be the same as those in the first aspect. Details are not described herein again.

In some implementations, the glass cover 120 is disposed on a housing of an electronic device, to protect a screen assembly. However, in a process of using the glass cover 120 of the electronic device, if no protective film is disposed, appearance defects such as scratches occur after long-term use. These defects destroy stress balance of the glass cover 120, resulting in a decrease in impact resistance of the glass cover 120.

In the conventional technology, a high-hardness optical film layer is disposed on an outer surface of a glass substrate 121, to improve scratch resistance of the glass cover 120. For example, a protective film formed by a high-hardness and high-refractive-index material and a protective film formed by a low-refractive-index material are alternately superposed on the surface of the glass substrate 121, to obtain a glass cover 120 with relatively strong scratch resistance. However, this solution cannot be used on a 3D glass substrate, especially a 3D glass substrate 121 whose bending angle is greater than 60°, and is suitable for use only on 2D and 2.5D glass substrates. This is because in a sputtering process of the 3D glass substrate, when a normal of a coating surface of the glass substrate 121 is parallel to an incident direction of a coating particle, a deposition speed is highest, and an optical film layer with uniform thickness may be obtained. However, when sputtering is performed on an edge, a specific angle α is formed between an arc surface normal and the incident direction of the coating particle, and a thickness of an obtained optical film layer changes with α by cosα. In this case, it cannot be ensured that colors of a plane and an arc surface on the 3D glass substrate are kept consistent. In addition, this process has a relatively high requirement on cleanliness of a production environment and the glass substrate 121, has a relatively low production yield, is suitable for use only on a small-size cover such as a mobile phone camera cover or a watch cover, and has a low yield on a large-area glass cover 120 such as a mobile phone or a tablet computer.

Alternatively, a diamond-like film whose Mohs hardness is close to 10 is deposited on the surface of the glass substrate 121 by using a diamond-like coating technology and a magnetic filtration technology or a CVD technology, to obtain an optical film layer with ultra-strong scratch resistance. However, the diamond-like film absorbs visible light to some extent, and consequently a thickness of the optical film layer is limited to be less than 50 nm. In actual use, the optical film layer is very prone to be pierced by harmful particles, and scratch resistance of the coated glass substrate 121 is not significantly improved.

In view of this, this application provides a glass cover 120. The glass cover 120 includes a glass substrate 121 and an optical film layer located on a surface of the glass substrate 121, and a refractive index of the optical film layer is 1.46-1.62. The optical film layer includes a first material and a second material that are atomic-level mixed, a mass ratio of the first material to the second material is (1~8):1, a refractive index of the first material> 1.6, and a refractive index of the second material< 1.52.

In the foregoing solution, the glass cover 120 uses the first material whose refractive index is greater than that of the glass substrate 121 and the second material whose refractive index is less than that of the glass substrate 121, and the first material and the second material are atomic-level mixed to form the optical film layer. The refractive index of the obtained optical film layer is close to that of the glass substrate 121, and does not affect transmittance and reflectivity of the glass substrate 121, and the refractive index of the optical film layer does not change with a thickness of the optical film layer. When the optical film layer is formed on a glass substrate 121 with an arc-shaped edge, no color difference in appearance of the glass substrate 121 is caused due to a change in the thickness of the optical film layer. In addition, when the optical film layer falls off, appearance of the glass cover 120 does not change.

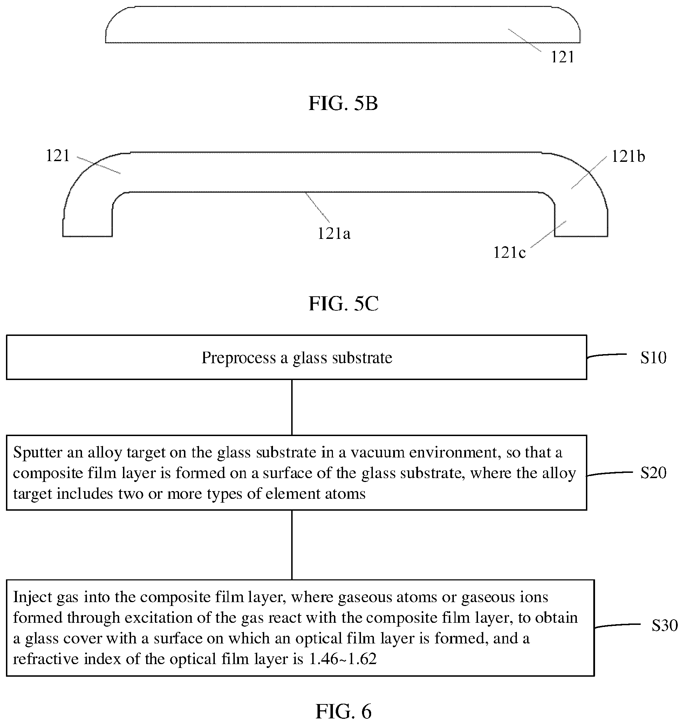

In some implementations, FIG. 5A, FIG. 5B, and FIG. 5C are respectively schematic diagrams of cross sections of a 2D glass substrate, a 2.5D glass substrate, and a 3D glass substrate of a mobile phone according to an embodiment of this application. As shown in FIG. 5A, FIG. 5B, and FIG. 5C, the glass substrate 121 used in this application includes one of the 2D glass substrate, the 2.5D glass substrate, and the 3D glass substrate. Specifically, the 2D glass substrate means that glass is of a flat plate structure. The 2.5D glass substrate means that on the basis that entire glass is located on a same plane, a relatively obvious arc-shaped transition is formed around the glass by using a numerical control machine tool processing technology. The 3D glass substrate means that a 3D curved surface is formed on a glass edge by using a hot bending mold, to present visual and experiential roundness. The 3D glass substrate includes a single-curved 3D glass substrate, a micro-double-curved 3D glass substrate, and a double-curved 3D glass substrate. For the single-curved 3D glass substrate, only left and right side edges are hot bent into a curved surface shape. For the double-curved 3D glass substrate, four edges are hot bent into a curved surface shape. For the micro-double-curved 3D glass substrate, angles and depths of upper and lower edges are reduced on the basis of the double-curved 3D glass substrate, to form a micro curved light and shadow effect on upper and lower sides. A structure of the glass substrate 121 may be selected based on an actual requirement. This is not limited herein.

It should be noted that a shape of the optical film layer in this application changes with a shape of the glass substrate 121. Therefore, the shape of the optical film layer is not limited.

Preferably, the glass substrate 121 used in this application is a 3D glass substrate. The 3D glass substrate is used as a base of the glass cover 120, so that an electronic device can have good appearance, and blocking of a signal of a mobile phone can be avoided.

In some implementations, the 3D glass substrate includes a base part 121a, a side part 121b, and a bent part 121c that connects the base part 121a and the side part 121b. The side part 121b and the bent part 121c are included, so that when a user observes the glass cover 120 from the front, the glass cover 120 is arc-shaped to some extent. Compared with a planar display structure, the 3D glass cover 120 is more in line with a structure of a human eye, and an electronic device that uses the glass cover 120 has a larger viewing angle, to improve comfort of using the electronic device.

Further, the optical film layer is formed on outer surfaces of the base part 121a, the bent part 121c, and the side part 121b, to improve scratch resistance of the 3D glass substrate. However, in a process of forming the optical film layer on the glass substrate 121, a thickness of the optical film layer on the surface of the bent part 121c is different from a thickness of the optical film layer on the surface of the base part 121a during sputtering. Therefore, a material of the optical film layer in this application includes the first material and the second material that are atomic-level mixed, the refractive index of the first material> 1.6, and the refractive index of the second material< 1.52. The first material includes at least one of Si₃N₄, Al₂O₃, AlN, ZrO₂, Nb₂O₅, T₂O₅, TiO₂, and the like. The second material includes at least one of SiO₂, MgF₂, LaF₃, AlF₃, and the like. The optical film layer whose refractive index is close to that of the glass substrate 121 is formed by using one or more of the foregoing first materials whose refractive index is greater than that of the glass substrate 121 and the foregoing second materials whose refractive index is less than that of the glass substrate 121.

Specifically, if a refractive index of air is n₀, the refractive index of the optical film layer is n₁, and the refractive index of the glass substrate 121 is n₃, the refractive index n₃ of the glass substrate 121 used in this application is 1.52, reflectivity R of the optical film layer should be less than or equal to 5.3%, and transmittance should≥90.5%. Based on a reflectivity calculation formula: $R = {\left[\frac{{n}_{0} - \frac{{n}_{1}^{2}}{{n}_{3}}}{{n}_{0} + \frac{{n}_{1}^{2}}{{n}_{3}}}\right]}^{2} ,$ it is obtained that the required refractive index n₁ of the optical film layer is approximately 1.56.

When the first material and the second material are mixed, based on a Lorentz-Lorenz dispersion theory formula of a multi-material mixed refractive index and a component ratio, a refractive index n obtained after the first material and the second material are mixed is as follows: ${n}^{2} = \frac{\left({\sum }_{i = 1}^{N} \frac{{a}_{i} {n}_{i}^{2} {c}_{i}}{{ρ}_{i}}\right)}{\left({\sum }_{i = 1}^{N} \frac{{a}_{i} {c}_{i}}{{ρ}_{i}}\right)}$

Herein, *aᵢ* = (*nᵢ* + 2)⁻¹*, pᵢ* is density of the first material and the second material, and *cᵢ* is percentage concentration of the first material and the second material.

For example, for preparation of an Al₂O₃-SiO₂ mixed film layer or Si₃N₄-SiO₂ mixed film layer, if percentage concentration and density of the high-refractive-index material Al₂O₃ or Si₃N₄ are respectively *cₕ* and *ρₕ,* and percentage concentration and density of SiO₂ are respectively *cₗ* and *ρₗ,* it may be learned that a refractive index n of the Al₂O₃-SiO₂ mixed film layer or Si₃N₄-SiO₂ mixed film layer is as follows: ${n}^{2} = \frac{\frac{{a}_{h} {n}_{h}^{2} {c}_{h}}{{ρ}_{h}} + \frac{{a}_{l} {n}_{l}^{2} {c}_{l}}{{ρ}_{l}}}{\frac{{a}_{h} {c}_{h}}{{ρ}_{h}} + \frac{{a}_{l} {c}_{l}}{{ρ}_{l}}}$

The mixed refractive index of the obtained optical film layer varies with a value of the percentage concentration *cₕ* of the high-refractive-index material Al₂O₃ or Si₃N₄, as shown in the following table.

| High-refractive-index material mass ratio | Mixed refractive index | |
|---|---|---|
| | SiO₂-Al₂O₃ | SiO₂-Si₃N₄ |
| 0.10 | 1.47 | 1.49 |
| 0.20 | 1.49 | 1.52 |
| 0.30 | 1.50 | 1.56 |
| 0.40 | 1.52 | 1.61 |
| 0.50 | 1.54 | 1.66 |
| 0.60 | 1.56 | 1.71 |
| 0.70 | 1.59 | 1.78 |
| 0.80 | 1.62 | 1.85 |
| 0.90 | 1.65 | 1.95 |
| 1.00 | 1.70 | 2.06 |

It may be learned from the foregoing example that by controlling the mass ratio of the first material to the second material, the optical film layer whose refractive index is approximately 1.56, that is, the optical film layer whose refractive index is close to that of the glass substrate 121, may be obtained. The mass ratio of the first material to the second material used in this application is (1~8):1. Optionally, the mass ratio of the first material to the second material is 1:1, 2:1, 3:1, 4:1, 5:1, 6:1, 7:1, 8:1, or the like, or may be another value in the range, and may be selected based on an actual requirement. This is not limited herein. If the mass ratio of the first material to the second material is excessively small, that is, a mass ratio of the first material with a high refractive index is excessively small, and a mass ratio of the second material with a low refractive index is excessively large, the refractive index of the prepared optical film layer is less than that of the glass substrate 121. If the mass ratio of the first material to the second material is excessively large, that is, a mass ratio of the first material with a high refractive index is excessively large, and a mass ratio of the second material with a low refractive index is excessively small, the refractive index of the prepared optical film layer is excessively high. If the refractive index of the optical film layer is excessively greater than or excessively less than that of the glass substrate 121, light transmission performance of the glass cover 120 is affected. Therefore, the mass ratio of the first material to the second material used in this application falls within the foregoing range. The refractive index of the prepared optical film layer is close to that of the glass substrate 121, and a change in the thickness of the optical film layer does not affect the refractive index of the optical film layer. Therefore, when the optical film layer is formed on a glass substrate 121 with an arc-shaped edge, for example, a 3D glass substrate, no color difference of the glass cover 120 is caused due to a difference between the thickness at the bent part 121c and the thickness at the base part 121a in a coating process. It may be learned that the refractive index of the optical film layer does not change with the thickness of the film layer. Although thicknesses of the optical film layer at the base part 121a, the side part 121b, and the bent part 121c are different, refractive indexes at the base part 121a, the side part 121b, and the bent part 121c are close to that of the glass, and no color difference in appearance is generated.

In addition, to improve scratch resistance of the optical film layer, Vickers hardness of the first material used in this application≥1000 HV. Optionally, the hardness of the first material may be specifically 1000 HV, 1100 HV, 1200 HV, 1300 HV, 1400 HV, 1500 HV, 1600 HV, 1700 HV, or the like, or may be another value in the range, and may be selected based on an actual requirement. This is not limited herein. If the hardness of the first material is excessively low, hardness of the prepared optical film layer is reduced, and in a process of using the electronic, the film layer is prone to be scratched, and consequently a service life of the optical film layer is shortened. The hardness of the first material used in the optical film layer in this application falls within the foregoing range, and the optical film layer has beauty and high hardness, is not prone to defects such as scratches in a use process, and has a long service life.

The optical film layer is prepared by using the first material that has high hardness and whose refractive index is greater than that of the glass substrate 121 and refractive index is less than that of the glass substrate 121. The optical film layer in this application may be prepared by using various deposition methods. For example, various film layers are formed by using a vacuum deposition technology, for example, chemical vapor deposition (for example, plasma-enhanced chemical vapor deposition, low pressure chemical vapor deposition, atmospheric pressure chemical vapor deposition, and plasma-enhanced atmospheric pressure chemical vapor deposition) and physical vapor deposition (for example, reactive or non-reactive sputtering or laser ablation, thermal or electron beam evaporation, or atomic layer deposition). A liquid-based method, for example, spraying, dip coating, spin coating, or slit coating (for example, using a sol-gel material) may alternatively be used. Preferably, the optical film layer in this application is formed in a metal target sputtering manner. FIG. 6 is a flowchart of preparation of a glass cover according to an embodiment of this application. As shown in FIG. 6, the following steps are included.

Step S10: Preprocess a glass substrate 121.

Step S20: Sputter an alloy target on the glass substrate 121 in a vacuum environment, so that a composite film layer is formed on a surface of the glass substrate 121, where the alloy target includes two or more types of element atoms.

Step S30: Inject gas into the composite film layer, where gaseous atoms or gaseous ions formed through excitation of the gas react with the composite film layer, to obtain a glass cover 120 with a surface on which an optical film layer is formed, and a refractive index of the optical film layer is 1.46-1.62.

In step S10, the preprocessing a glass substrate 121 is a cleaning process, and the glass substrate 121 is cleaned. Specifically, the glass substrate 121 is placed in a deionized water immersion cleaning tank, deionized water is added to the cleaning tank to immerse the glass substrate 121, and an ultrasonic generator in the deionized water immersion cleaning tank runs to emit an ultrasonic wave, so as to perform one time of cleaning. Then, the glass substrate 121 is placed in a deionized water spraying cleaning tank, and a water pipe nozzle in the deionized water spraying cleaning tank sprays out deionized water to rinse the glass substrate 121, so as to perform secondary cleaning. Then, the glass substrate 121 is placed in a drying device, and dried. After cleaning, the glass substrate 121 and the surface are clean, and there is a stronger binding force to the optical film layer, to facilitate a subsequent preparation process. Another cleaning manner may be selected, and may be selected based on an actual requirement. This is not limited herein.

In step S20, a sputtering device in this application is a vertical monomeric magnetron furnace, a sputtering material is a pure metal target that is uniformly mixed and whose purity is greater than 99%, and the pure metal target includes two types of metal atoms. A preparation method for the pure metal target may be a casting method or a powder metallurgy method. Specifically, the casting method is to melt first metal and second metal with a ratio of (1~8):1 to obtain an alloy solution, then pour the alloy solution into a mold to form an ingot, and finally prepare the target through mechanical processing. A melting method may be vacuum induction melting, vacuum arc melting, vacuum electron bombardment melting, and the like. The powder metallurgy method is to melt first metal and second metal with a specific composition ratio, perform pouring to form an ingot, then perform pulverizing, perform isostatic pressing on powder formed through pulverizing, then perform high sintering, and finally form the target. The metal target may be formed in another manner, and may be selected based on an actual requirement. This is not limited herein.

After being prepared, the metal target is placed in the vertical monomeric magnetron furnace. Under a condition that a vacuum degree is 3.6E⁻³pa and working pressure is 5.6E⁻¹-6.6E⁻¹, the vertical monomeric magnetron furnace is turned on. For the glass substrate 121, the metal target is used, an electron generated by a glow discharge excites inert gas in the sputtering device to generate a plasma, the plasma blasts out a first metal atom and a second metal atom of the metal target, and the first metal atom and the second metal atom are deposited on the glass substrate 121, to form the composite film layer.

In step S30, a gas excitation process is implemented by using an ICP plasma ionizer. Specifically, after the working gas enters the ICP plasma ionizer, a high-frequency current generates a high-frequency electromagnetic field through an induction coil of the ICP plasma ionizer, so that the working gas is ionized to form a gas plasma. In this case, the composite film layer on the glass substrate 121 reacts with the gas plasma, to form the optical film layer. The gas used in this application is oxygen, nitrogen, or the like.

It should be noted that in the process in which the composite film layer reacts with the gas plasma, a rotation speed of the glass substrate 121 is kept at 50 r/min-120 r/min. Optionally, the rotation speed may be specifically 50 r/min, 60 r/min, 70 r/min, 80 r/min, 90 r/min, 100 r/min, 110 r/min, 120 r/min, or the like, or may be another value in the range, and may be selected based on an actual requirement. This is not limited herein. If the rotation speed of the glass substrate 121 is excessively high or excessively low, the composite film layer cannot fully react with the gas, the reaction is incomplete, and the prepared optical film layer cannot meet a required requirement.

The optical film layer prepared according to the foregoing preparation method is scratch-resistant and has other excellent physical performance, for example, characteristics such as high hardness, smoothness, and excellent light transmittance and refractive index performance.

In some implementations, a thickness of the optical film layer is 500 nm~5000 nm. Optionally, the thickness of the optical film layer may be specifically 500 nm, 1000 nm, 1500 nm, 2000 nm, 2500 nm, 3000 nm, 3500 nm, 4000 nm, 4500 nm, 5000 nm, or the like, or may be another value in the range, and may be selected based on an actual requirement. This is not limited herein. If the thickness of the optical film layer is excessively high, hardness is high, and scratch resistance is strong, but a thickness of the glass cover 120 is increased, and beauty of an electronic device is affected. If the thickness of the optical film layer is excessively low, scratch resistance is decreased, and a service life is short. When the thickness of the optical film layer prepared in this application falls within the foregoing range, both characteristics of high hardness and good beauty are achieved.

In some implementations, when testing is performed by using a Mohs hardness tester pen, Mohs hardness of the optical film layer≥7 under the action of a test force of 500 g. The Mohs hardness means that by using a scoring method, a pyramid-shaped diamond needle is used to scratch a surface of the tested optical film layer, a depth of a scratch is measured, and the depth of the scratch is the Mohs hardness. In this application, the optical film layer is prepared by using the first material with high hardness, so that the Mohs hardness of the optical film layer falls within the foregoing range, and the optical film layer has better scratch resistance.

When testing is performed by using a Vickers indentation meter, Vickers hardness of the optical film layer≥1100 HV under the action of a load force of 18 mN. The Vickers hardness means that a diamond regular pyramid indenter with an included angle of 136 degrees between opposite surfaces is pressed into a surface of the optical film layer under the action of a specified load F, the load is removed after being maintained for a fixed time, a diagonal length d of an indentation is measured, then an indentation surface area is calculated, and finally average pressure on the indentation surface area is obtained, and is a Vickers hardness value of the material. In this application, the optical film layer is prepared by using the first material with high hardness. The Vickers hardness of the optical film layer falls within the foregoing range, and the optical film layer has good pressure resistance. In a process of using the electronic device, when a sharp object or a heavy object squeezes the electronic device, the optical film layer may play a good protection role.

In some implementations, a friction coefficient of the optical film layer is 0.01-0.06. Optionally, the friction coefficient of the optical film layer may be specifically 0.01, 0.015, 0.02, 0.025, 0.03, 0.035, 0.04, 0.045, 0.050.055, 0.06, or the like, or may be another value in the range, and may be selected based on an actual requirement. This is not limited herein. The optical film layer is disposed on a side that is of the glass substrate 121 and that is away from another part of the electronic device. In a process of using the electronic device, an outer surface of the optical film layer is in contact with a finger of a user. If the friction coefficient of the optical film layer is excessively large, experience is prone to be degraded when the user frequently performs an operation on the electronic device. If the friction coefficient is excessively small, the electronic device is prone to receive an action instruction when the user unintentionally performs an operation. The friction coefficient of the optical film layer prepared in this application is controlled within this range, so that the optical film layer is smooth and enables the electronic device to receive a correct instruction.

In some implementations, transmittance of the optical film layer for visible light whose wavelength falls within 380 nm~780 nm>90%. Specifically, the transmittance of the optical film layer may be specifically 90%, 91%, 92%, 93%, 94%, 95%, 96%, or the like, or may be another value in the range, and may be selected based on an actual requirement. This is not limited herein. The transmittance refers to a percentage of light that passes. Higher transmittance indicates clearer display of the glass cover 120. The glass cover 120 is mounted on the electronic device, and the optical film layer is disposed on a side that is of the glass cover 120 and that is away from another part of the electronic device. When a display generates a display image, light of the display image passes through the glass cover 120 and then is received by a user. If the transmittance of the optical film layer is excessively low, brightness of the electronic device is reduced, and user experience is degraded. The transmittance of the optical film layer prepared in this application falls within the foregoing range, and the display image observed by the user through the glass cover 120 is clear.

In some implementations, reflectivity of the optical film layer for visible light whose wavelength falls within 380 nm~780 nm<6%. Specifically, the reflectivity of the optical film layer may be specifically 6%, 4.2%, 3.5%, 3%, 2.5%, 2%, 1.5%, 1%, or the like, or may be another value in the range, and may be selected based on an actual requirement. This is not limited herein. The reflectivity of the optical film layer refers to a degree to which the optical film layer reflects light. Lower reflectivity of the optical film layer indicates a smaller amount of light reflected by the optical film layer, so that when the electronic device is used, experience closer to that of using paper is achieved by the display, and a better human feeling is achieved. If the reflectivity of the optical film layer is excessively high, when the electronic device is used in a strong light environment, a viewing process of the electronic device is affected. The reflectivity of the optical film layer prepared in this application falls within this range, and the user may have good viewing or reading experience on the electronic device.

In some implementations, the refractive index of the optical film layer is 1.46-1.62. Specifically, the refractive index of the optical film layer may be specifically 1.46, 1.47, 1.49, 1.50, 1.52, 1.54, 1.56, 1.59, 1.62, or the like, or may be another value in the range, and may be selected based on an actual requirement. This is not limited herein. The optical film layer is formed on a side that is of the glass substrate 121 and that is away from another part of the electronic device. In a use process, the user observes content on the display through the glass cover 120. If the refractive index of the optical film layer is excessively high or excessively low, that is, the refractive index of the optical film layer is not close to that of the glass substrate 121, light transmittance and reflectivity of the glass substrate 121 are affected, and user experience is degraded.

In some implementations, in an (L*, a*, b*) colorimetric system, an a* value and a b* value of reflected light that can be reflected by the optical film layer are respectively -2-2 and - 2~2; and/or an a* value and a b* value of transmitted light that can be transmitted by the optical film layer are respectively -2-2 and -2-2. L* represents lightness, ranges from 0 to, and indicates a color change from dark (black) to light (white); a* indicates red and green, has a value change from positive to negative, and indicates a color change from red (positive) to green (negative), a larger a value indicates a redder color, and a smaller a value indicates a greener color; and b* indicates yellow and blue, has a value change from positive to negative, and indicates a color change from yellow (positive) to blue (negative), a larger b value indicates a yellower color, and a smaller b value indicates a bluer color. Specifically, the a* value and the b* value may be specifically -2, -1.5, -1, -0.5, 0.5, 1, 1.5, 2, or the like, or may be another value in the range, and may be selected based on an actual requirement. This is not limited herein. The a* value and the b* value of each of the transmitted light and the reflected light of the optical film layer prepared in this application fall within this range, and the glass cover 120 of the electronic device does not appear to have a defect such as a rainbow edge.

A side that is of the optical film layer and that is away from the glass substrate 121 is a touch surface of the user. In a use process of the user, a fingerprint or dirt is prone to be left at the optical film layer, and light transmittance and beauty of the optical film layer are affected. Therefore, the glass cover 120 further includes a protective layer, and the protective layer is disposed on the side that is of the optical film layer and that is away from the glass substrate 121. The protective layer is disposed on the side that is of the optical film layer and that is away from the glass substrate 121, to prevent adhesion of a fingerprint and a contaminant, so as to further enhance a service life of the optical film layer while improving user experience.

The following provides descriptions with reference to specific embodiments.

### Embodiment 1

A 3D glass substrate is cleaned by using deionized water, and placed in a vertical monomeric magnetron furnace.

The vertical monomeric magnetron furnace is turned on, and under a working condition that a vacuum degree is 3.6E⁻³pa, and working pressure is 5.6E⁻¹-6.6E⁻¹, a silicon-aluminum alloy target is sputtered on the 3D glass substrate, so that a composite film layer is formed on a surface of the 3D glass substrate. A mass ratio of silicon oxide to aluminum oxide is 3:2.

Oxygen is injected into the vertical monomeric magnetron furnace, and gaseous atoms or gaseous ions formed by exciting the oxygen by an ICP plasma ionizer react with the composite film layer on the glass substrate with a rotation speed of 85 r/min, to obtain a glass cover with a surface on which an optical film layer with a thickness of 2500 nm is formed.

The cover coated with a hard film is placed in an electron gun evaporation furnace. The electron gun evaporation furnace is turned on, and coating parameters are set: coating current: 90 mA, Ar flow rate: 220 sccm, and coating time: 3 min, to obtain a perfluoropolyether anticontamination film layer with a thickness of 10 nm-30 nm.

For the optical film layer prepared in Embodiment 1, Mohs hardness is 7 (under a force of 600 g), Vickers hardness is 1205 HV, a friction coefficient is 0.026, transmittance is 91.7%, reflectivity is 8.1%, a refractive index is 1.51, an a* value and a b* value of reflected light that is reflected are respectively 0.01 and 0.02, an a* value and a b* value of transmitted light that can be transmitted are respectively -0.01 and 0.02, and there is no visual rainbow pattern on a 3D arc-shaped edge.

### Embodiment 2

A 3D glass substrate is cleaned by using deionized water, and placed in a vertical monomeric magnetron furnace.

The vertical monomeric magnetron furnace is turned on, and under a working condition that a vacuum degree is 3.6E⁻³pa, and working pressure is 5.6E⁻¹-6.6E⁻¹, a silicon-aluminum alloy target is sputtered on the 3D glass substrate, so that a composite film layer is formed on a surface of the 3D glass substrate. A mass ratio of silicon oxide to aluminum oxide is 2:3.

Oxygen is injected into the vertical monomeric magnetron furnace, and gaseous atoms or gaseous ions formed by exciting the oxygen by an ICP plasma ionizer react with the composite film layer on the glass substrate with a rotation speed of 85 r/min, to obtain a glass cover with a surface on which an optical film layer with a thickness of 2500 nm is formed.

The cover coated with a hard film is placed in an electron gun evaporation furnace. The electron gun evaporation furnace is turned on, and coating parameters are set: coating current: 90 mA, Ar flow rate: 220 sccm, and coating time: 3 min, to obtain a perfluoropolyether anticontamination film layer with a thickness of 10 nm-30 nm.

For the optical film layer prepared in Embodiment 2, Mohs hardness is 7 (under a force of 1100 g), Vickers hardness is 1380 HV, a friction coefficient is 0.026, transmittance is 91.3%, reflectivity is 8.3%, a refractive index is 1.56, an a* value and a b* value of reflected light that is reflected are respectively -0.01 and -0.01, an a* value and a b* value of transmitted light that can be transmitted are respectively 0.01 and 0.1, and there is no visual rainbow pattern on a 3D arc-shaped edge.

### Embodiment 3

A 3D glass substrate is cleaned by using deionized water, and placed in a vertical monomeric magnetron furnace.

The vertical monomeric magnetron furnace is turned on, and under a working condition that a vacuum degree is 3.6E⁻³pa, and working pressure is 5.6E⁻¹-6.6E⁻¹, a silicon-aluminum alloy target is sputtered on the 3D glass substrate, so that a composite film layer is formed on a surface of the 3D glass substrate. A mass ratio of silicon oxide to aluminum oxide is 1:4.

Oxygen is injected into the vertical monomeric magnetron furnace, and gaseous atoms or gaseous ions formed by exciting the oxygen by an ICP plasma ionizer react with the composite film layer on the glass substrate with a rotation speed of 85 r/min, to obtain a glass cover with a surface on which an optical film layer with a thickness of 2500 nm is formed.

The cover coated with a hard film is placed in an electron gun evaporation furnace. The electron gun evaporation furnace is turned on, and coating parameters are set: coating current: 90 mA, Ar flow rate: 220 sccm, and coating time: 3 min, to obtain a perfluoropolyether anticontamination film layer with a thickness of 10 nm-30 nm.

For the optical film layer prepared in Embodiment 3, Mohs hardness is 7 (under a force of 1500 g), Vickers hardness is 1560 HV, a friction coefficient is 0.029, transmittance is 90.7%, reflectivity is 9.1%, a refractive index is 1.62, an a* value and a b* value of reflected light that is reflected are respectively -0.2 and -0.26, an a* value and a b* value of transmitted light that can be transmitted are respectively 0.1 and 0.3, and there is no visual rainbow pattern on a 3D arc-shaped edge.

### Embodiment 4

A 3D glass substrate is cleaned by using deionized water, and placed in a vertical monomeric magnetron furnace.

The vertical monomeric magnetron furnace is turned on, and under a working condition that a vacuum degree is 3.6E⁻³pa, and working pressure is 5.6E⁻¹-6.6E⁻¹, a silicon target is sputtered on the 3D glass substrate, and an ICP ionizer is used to react with nitrogen and oxide ions, so that a composite film layer is formed on a surface of the 3D glass substrate. A mass ratio of silicon oxide to silicon nitride is 1:4.

Oxygen and nitrogen are injected into the vertical monomeric magnetron furnace, and gaseous atoms or gaseous ions formed by exciting the oxygen and the nitrogen by an ICP plasma ionizer react with the composite film layer on the glass substrate with a rotation speed of 85 r/min, to obtain a glass cover with a surface on which an optical film layer with a thickness of 2500 nm is formed.

The cover coated with a hard film is placed in an electron gun evaporation furnace. The electron gun evaporation furnace is turned on, and coating parameters are set: coating current: 90 mA, Ar flow rate: 220 sccm, and coating time: 3 min, to obtain a perfluoropolyether anticontamination film layer with a thickness of 10 nm-30 nm.

For the optical film layer prepared in Embodiment 4, Mohs hardness is 7 (under a force of 600 g), Vickers hardness is 1160 HV, a friction coefficient is 0.024, transmittance is 91.8%, reflectivity is 8%, a refractive index is 1.51, an a* value and a b* value of reflected light that is reflected are respectively -0.01 and 0.02, an a* value and a b* value of transmitted light that can be transmitted are respectively 0.01 and 0.00, and there is no visual rainbow pattern on a 3D arc-shaped edge.

### Embodiment 5

A 3D glass substrate is cleaned by using deionized water, and placed in a vertical monomeric magnetron furnace.

The vertical monomeric magnetron furnace is turned on, and under a working condition that a vacuum degree is 3.6E⁻³pa, and working pressure is 5.6E⁻¹-6.6E⁻¹, a silicon target is sputtered on the 3D glass substrate, and an ICP ionizer is used to react with nitrogen and oxide ions, so that a composite film layer is formed on a surface of the 3D glass substrate. A mass ratio of silicon oxide to silicon nitride is 7:3.

Oxygen and nitrogen are injected into the vertical monomeric magnetron furnace, and gaseous atoms or gaseous ions formed by exciting the oxygen and the nitrogen by an ICP plasma ionizer react with the composite film layer on the glass substrate with a rotation speed of 85 r/min, to obtain a glass cover with a surface on which an optical film layer with a thickness of 2500 nm is formed.

The cover coated with a hard film is placed in an electron gun evaporation furnace. The electron gun evaporation furnace is turned on, and coating parameters are set: coating current: 90 mA, Ar flow rate: 220 sccm, and coating time: 3 min, to obtain a perfluoropolyether anticontamination film layer with a thickness of 10 nm-30 nm.

For the optical film layer prepared in Embodiment 5, Mohs hardness is 7 (under a force of 1100 g), Vickers hardness is 1280 HV, a friction coefficient is 0.026, transmittance is 91.3%, reflectivity is 8.3%, a refractive index is 1.56, an a* value and a b* value of reflected light that is reflected are respectively -0.1 and -0.25, an a* value and a b* value of transmitted light that can be transmitted are respectively -0.01 and 0.28, and there is no visual rainbow pattern on a 3D arc-shaped edge.

### Embodiment 6

A 3D glass substrate is cleaned by using deionized water, and placed in a vertical monomeric magnetron furnace.

The vertical monomeric magnetron furnace is turned on, and under a working condition that a vacuum degree is 3.6E⁻³pa, and working pressure is 5.6E⁻¹-6.6E⁻¹, a silicon target is sputtered on the 3D glass substrate, and an ICP ionizer is used to react with nitrogen and oxide ions, so that a composite film layer is formed on a surface of the 3D glass substrate. A mass ratio of silicon oxide to silicon nitride is 3:2.

Oxygen and nitrogen are injected into the vertical monomeric magnetron furnace, and gaseous atoms or gaseous ions formed by exciting the oxygen and the nitrogen by an ICP plasma ionizer react with the composite film layer on the glass substrate with a rotation speed of 85 r/min, to obtain a glass cover with a surface on which an optical film layer with a thickness of 2500 nm is formed.

The cover coated with a hard film is placed in an electron gun evaporation furnace. The electron gun evaporation furnace is turned on, and coating parameters are set: coating current: 90 mA, Ar flow rate: 220 sccm, and coating time: 3 min, to obtain a perfluoropolyether anticontamination film layer with a thickness of 10 nm-30 nm.

For the optical film layer prepared in Embodiment 6, Mohs hardness is 7 (under a force of 1500 g), Vickers hardness is 1480 HV, a friction coefficient is 0.036, transmittance is 90.8%, reflectivity is 9.0%, a refractive index is 1.61, an a* value and a b* value of reflected light that is reflected are respectively 0.01 and -0.24, an a* value and a b* value of transmitted light that can be transmitted are respectively -0.03 and 0.26, and there is no visual rainbow pattern on a 3D arc-shaped edge.

### Comparative Example 1

A 3D glass substrate is cleaned by using deionized water.

A first film layer and a second film layer are alternately superposed on a surface of the 3D glass substrate, to form a composite film layer with a thickness of 2500 nm. A refractive index and Mohs hardness of the first film layer are respectively 1.46 and 870 HV, and a refractive index and Mohs hardness of the second film layer are respectively 2.1 and 1970 HV.

For the optical film layer prepared in Comparative Example 1, Mohs hardness is 7 (under a force of 1500 g), Vickers hardness is 1428 HV, a friction coefficient is 0.055, transmittance is 94.48%, reflectivity is 4.2%, an a* value and a b* value of reflected light that is reflected are respectively 0.19 and -0.86, and an a* value and a b* value of transmitted light that can be transmitted are respectively -0.24 and 0.87, and there is a visual rainbow pattern on a 3D arc-shaped edge.

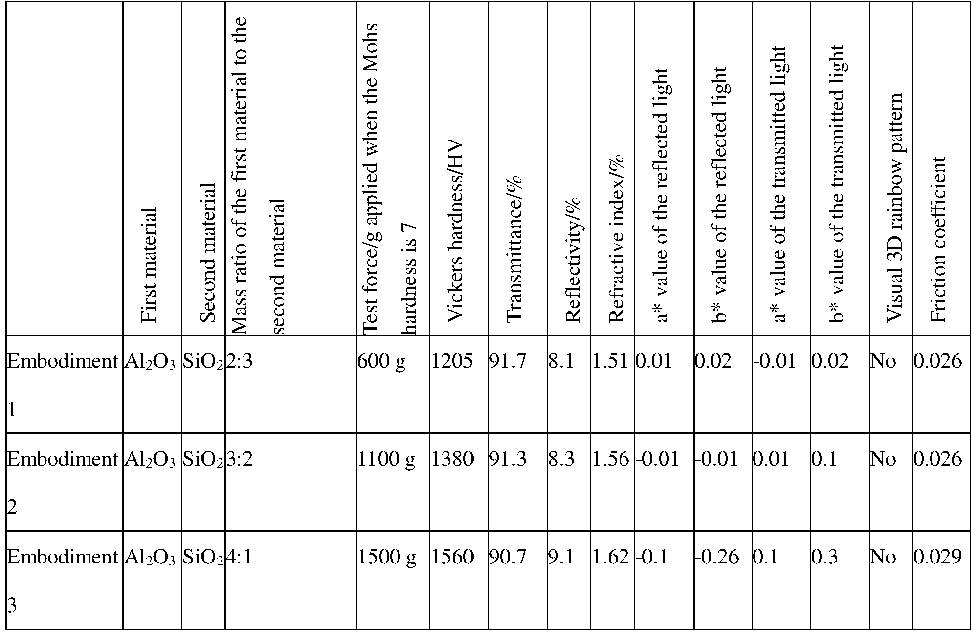

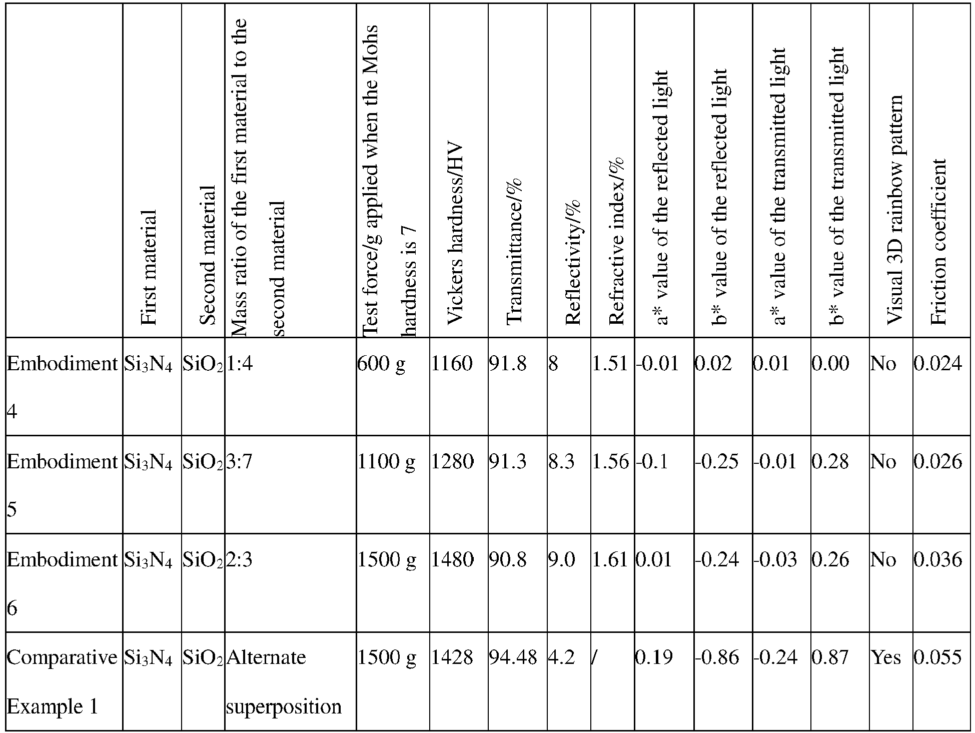

It may be learned from Embodiment 1 to Embodiment 6 and Comparative Example 1 that the glass cover in this application uses the first material whose refractive index is greater than that of the glass substrate and the second material whose refractive index is less than that of the glass substrate. When the mass ratio of the first material to the second material falls within the range of (1~8):1, compared with a stacked arrangement of a conventional optical film layer, the first material and the second material in this application are atomic-level mixed to form the optical film layer. The refractive index of the obtained optical film layer is 1.46-1.62, is close to that of the glass substrate, and does not affect transmittance and reflectivity of the glass substrate, and the refractive index of the optical film layer does not change with a thickness of the optical film layer. When the optical film layer is formed on a glass substrate with an arc-shaped edge, no color difference in appearance of the glass substrate is caused due to a change in the thickness of the film layer. In addition, when the film layer falls off, appearance of the glass cover does not change.

## Claims

1. A glass cover, comprising a glass substrate and an optical film layer located on a surface of the glass substrate, a refractive index of the optical film layer being 1.46~1.62; and the optical film layer comprising a first material and a second material that are atomic-level mixed, a mass ratio of the first material to the second material being (1~8):1, a refractive index of the first material > 1.6, and a refractive index of the second material <1.52,
wherein the first material comprises at least one of Si₃N₄, Al₂O₃, AlN, ZrO₂, Nb₂O₅, Ta₂O₅, and TiO₂, and
wherein the second material comprises at least one of SiO₂, MgF₂, LaF₃, and AlF₃.

2. The glass cover according to claim 1, wherein the Vickers hardness of the first material≥1000 HV.

3. The glass cover according to claim 1, wherein the glass cover meets at least one of the following features:
(1) a thickness of the optical film layer is 500 nm~5000 nm;
(2) when testing is performed by using a Mohs hardness tester pen, Mohs hardness of the optical film layer ≥7 under the action of a test force of 500 g;
(3) when testing is performed by using a Vickers indentation meter, Vickers hardness of the optical film layer≥1100 HV under the action of a load force of 18 mN;
(4) a friction coefficient of the optical film layer is 0.01~0.06;
(5) transmittance of the optical film layer for visible light whose wavelength falls within 380 nm~780 nm >90%;
(6) reflectivity of the optical film layer for visible light whose wavelength falls within 380 nm~780 nm <6%; and
(7) the glass cover further comprises a protective layer, and the protective layer is disposed on a side that is of the optical film layer and that is away from the glass substrate.

4. The glass cover according to claim 1, wherein the glass substrate comprises one of a 2D glass substrate, a 2.5D glass substrate, and a 3D glass substrate.

5. The glass cover according to claim 1, wherein the glass substrate is a 3D glass substrate, and the 3D glass substrate comprises a base part, a side part, and a bent part that connects the base part and the side part; and
the optical film layer is formed on surfaces of the base part, the bent part, and the side part, and a thickness of the optical film layer on the surface of the bent part is different from a thickness of the optical film layer on the surface of the base part.

6. The glass cover according to claim 1, wherein in an (L*, a*, b*) colorimetric system, an a* value and a b* value of reflected light that can be reflected by the optical film layer are respectively -2-2 and -2-2; and/or an a* value and a b* value of transmitted light that can be transmitted by the optical film layer are respectively -2-2 and -2-2.

7. A preparation method for a glass cover, comprising:
preprocessing a glass substrate;
sputtering an alloy target on the glass substrate in a vacuum environment, so that a composite film layer is formed on a surface of the glass substrate, wherein the alloy target comprises two types of element atoms; and
injecting gas into the composite film layer, wherein gaseous atoms or gaseous ions of a gas plasma formed through excitation of the gas react with the composite film layer, to obtain a glass cover with a surface on which an optical film layer is formed, and a refractive index of the optical film layer is 1.46-1.62, wherein the optical film layer comprises a first material and a second material that are atomic-level mixed, a mass ratio of the first material to the second material being (1~8):1, a refractive index of the first material >1.6, and a refractive index of the second material <1.52, wherein the first material comprises at least one of Si₃N₄, Al₂O₃, AlN, ZrO₂, Nb₂O₅, Ta₂O₅, and TiO₂, wherein the second material comprises at least one of SiO₂, MgF₂, LaF₃, and AlF₃, and
wherein, in the process in which the composite film layer reacts with the gas plasma, a rotation speed of the glass substrate is kept at 50 r/min~120 r/min.

8. An electronic device, comprising the glass cover according to any one of claims 1 to 6 or a glass cover prepared according to the preparation method for a glass cover according to claim 7.

## Patentansprüche

1. Glasabdeckung, umfassend ein Glassubstrat und eine optische Filmschicht, die sich auf einer Oberfläche des Glassubstrats befindet, wobei ein Brechungsindex der optischen Filmschicht 1,46 bis 1,62 beträgt; und wobei die optische Filmschicht ein erstes Material und ein zweites Material umfasst, die auf atomarer Ebene gemischt sind, wobei ein Massenverhältnis des ersten Materials zu dem zweiten Material (1 bis 8):1 beträgt, wobei ein Brechungsindex des ersten Materials größer als 1,6 ist und ein Brechungsindex des zweiten Materials kleiner als 1,52 ist,
wobei das erste Material mindestens eines von Si₃N₄, Al₂O₃, AlN, ZrO₂, Nb₂O₅, Ta₂O₅ und TiO₂ umfasst, und
wobei das zweite Material mindestens eines von SiO₂, MgF₂, LaF₃ und AlF₃ umfasst.

2. Glasabdeckung nach Anspruch 1, wobei die Vickershärte des ersten Materials ≥ 1000 HV beträgt.

3. Glasabdeckung nach Anspruch 1, wobei die Glasabdeckung mindestens eines der folgenden Merkmale erfüllt:
(1) eine Dicke der optischen Filmschicht 500 nm bis 5000 nm beträgt;
(2) wenn eine Prüfung unter Verwendung eines Mohshärte-Prüfstifts durchgeführt wird, die Mohshärte der optischen Filmschicht unter der Einwirkung einer Prüfkraft von 500 g ≥ 7 beträgt;
(3) wenn eine Prüfung unter Verwendung eines Vickers-Eindruckmessgeräts durchgeführt wird, die Vickershärte der optischen Filmschicht unter der Einwirkung einer Lastkraft von 18 mN ≥ 1100 HV beträgt;
(4) ein Reibungskoeffizient der optischen Filmschicht 0,01 bis 0,06 beträgt;
(5) die Durchlässigkeit der optischen Filmschicht für sichtbares Licht, dessen Wellenlänge im Bereich von 380 nm bis 780 nm liegt, > 90 % beträgt;
(6) das Reflexionsvermögen der optischen Filmschicht für sichtbares Licht, dessen Wellenlänge im Bereich von 380 nm bis 780 nm liegt, < 6 % beträgt; und
(7) die Glasabdeckung umfasst ferner eine Schutzschicht, und die Schutzschicht ist auf einer von dem Glassubstrat abgewandten Seite der optischen Filmschicht angeordnet.

4. Glasabdeckung nach Anspruch 1, wobei das Glassubstrat eines von einem 2D-Glassubstrat, einem 2,5D-Glassubstrat und einem 3D-Glassubstrat umfasst.

5. Glasabdeckung nach Anspruch 1, wobei das Glassubstrat ein 3D-Glassubstrat ist, und das 3D-Glassubstrat ein Basisteil, ein Seitenteil und ein Biegeteil umfasst, das das Basisteil und das Seitenteil verbindet; und
die optische Filmschicht auf Oberflächen des Basisteils, des Biegeteils und des Seitenteils ausgebildet ist und eine Dicke der optischen Filmschicht auf der Oberfläche des Biegeteils von einer Dicke der optischen Filmschicht auf der Oberfläche des Basisteils verschieden ist.

6. Glasabdeckung nach Anspruch 1, wobei in einem (L*, a*, b*)-Farbsystem ein a*-Wert und ein b*-Wert von reflektiertem Licht, das durch die optische Filmschicht reflektiert werden kann, jeweils -2 bis 2 und -2 bis 2 betragen; und/oder ein a*-Wert und ein b*-Wert von durchgelassenem Licht, das durch die optische Filmschicht durchgelassen werden kann, jeweils -2 bis 2 und -2 bis 2 betragen.

7. Herstellungsverfahren für eine Glasabdeckung, umfassend:
Vorverarbeiten eines Glassubstrats;
Sputtern eines Legierungstargets auf das Glassubstrat in einer Vakuumumgebung, so dass eine Verbundfilmschicht auf einer Oberfläche des Glassubstrats ausgebildet wird, wobei das Legierungstarget zwei Arten von Elementatomen umfasst; und
Einleiten von Gas in die Verbundfilmschicht, wobei gasförmige Atome oder gasförmige Ionen eines durch Anregung des Gases gebildeten Gasplasmas mit der Verbundfilmschicht reagieren, um eine Glasabdeckung mit einer Oberfläche zu erhalten, auf der eine optische Filmschicht ausgebildet ist, und ein Brechungsindex der optischen Filmschicht 1,46 bis 1,62 beträgt, wobei die optische Filmschicht ein erstes Material und ein zweites Material umfasst, die auf atomarer Ebene gemischt sind, wobei ein Massenverhältnis des ersten Materials zu dem zweiten Material (1 bis 8):1 beträgt, wobei ein Brechungsindex des ersten Materials größer als 1,6 ist und ein Brechungsindex des zweiten Materials kleiner als 1,52 ist, wobei das erste Material mindestens eines von Si₃N₄, Al₂O₃, AlN, ZrO₂, Nb₂O₅, Ta₂O₅ und TiO₂ umfasst, wobei das zweite Material mindestens eines von SiO₂, MgF₂, LaF₃ und AlF₃ umfasst, und
wobei während des Prozesses, in dem die Verbundfilmschicht mit dem Gasplasma reagiert, eine Rotationsgeschwindigkeit des Glassubstrats auf 50 U/min bis 120 U/min gehalten wird.

8. Elektronische Vorrichtung, umfassend die Glasabdeckung nach einem der Ansprüche 1 bis 6 oder eine gemäß dem Herstellungsverfahren für eine Glasabdeckung nach Anspruch 7 hergestellte Glasabdeckung.

## Revendications

1. Couvercle en verre, comprenant un substrat en verre et une couche de film optique située sur une surface du substrat en verre, un indice de réfraction de la couche de film optique étant de 1,46 à 1,62 ; et la couche de film optique comprenant un premier matériau et un deuxième matériau qui sont mélangés au niveau atomique, un rapport de masse du premier matériau au deuxième matériau étant de (1 à 8):1, un indice de réfraction du premier matériau étant > 1,6, et un indice de réfraction du deuxième matériau étant < 1,52,
dans lequel le premier matériau comprend au moins un de Si₃N₄, Al₂O₃, AlN, ZrO₂, Nb₂O₅, Ta₂O₅, et TiO₂, et
dans lequel le deuxième matériau comprend au moins un de SiO₂, MgF₂, LaF₃, et AlF₃.

2. Couvercle en verre selon la revendication 1, dans lequel la dureté Vickers du premier matériau est ≥ 1000 HV.

3. Couvercle en verre selon la revendication 1, dans lequel le couvercle en verre satisfait à au moins l'une des caractéristiques suivantes :
(1) une épaisseur de la couche de film optique est de 500 nm à 5000 nm ;
(2) lorsqu'un test est effectué en utilisant un stylo testeur de dureté Mohs, la dureté Mohs de la couche de film optique est ≥ 7 sous l'action d'une force de test de 500 g ;
(3) lorsqu'un test est effectué en utilisant un appareil de mesure d'indentation Vickers, la dureté Vickers de la couche de film optique est ≥ 1100 HV sous l'action d'une force de charge de 18 mN ;
(4) un coefficient de frottement de la couche de film optique est de 0,01 à 0,06 ;
(5) la transmittance de la couche de film optique pour la lumière visible dont la longueur d'onde se situe dans la plage de 380 nm à 780 nm est > 90 % ;
(6) la réflectivité de la couche de film optique pour la lumière visible dont la longueur d'onde se situe dans la plage de 380 nm à 780 nm est < 6 % ; et
(7) le couvercle en verre comprend en outre une couche protectrice, et la couche protectrice est disposée sur un côté de la couche de film optique qui est tourné à l'opposé du substrat en verre.

4. Couvercle en verre selon la revendication 1, dans lequel le substrat en verre comprend l'un d'un substrat en verre 2D, d'un substrat en verre 2,5D, et d'un substrat en verre 3D.

5. Couvercle en verre selon la revendication 1, dans lequel le substrat en verre est un substrat en verre 3D, et le substrat en verre 3D comprend une partie de base, une partie latérale, et une partie courbée qui relie la partie de base et la partie latérale ; et
la couche de film optique est formée sur les surfaces de la partie de base, de la partie courbée, et de la partie latérale, et une épaisseur de la couche de film optique sur la surface de la partie courbée est différente d'une épaisseur de la couche de film optique sur la surface de la partie de base.

6. Couvercle en verre selon la revendication 1, dans lequel, dans un système colorimétrique (L*, a*, b*), une valeur a* et une valeur b* de la lumière réfléchie qui peut être réfléchie par la couche de film optique sont respectivement de -2 à 2 et de -2 à 2 ; et/ou une valeur a* et une valeur b* de la lumière transmise qui peut être transmise par la couche de film optique sont respectivement de -2 à 2 et de -2 à 2.

7. Procédé de préparation d'un couvercle en verre, comprenant :
le prétraitement d'un substrat en verre ;
la pulvérisation d'une cible en alliage sur le substrat en verre dans un environnement sous vide, de sorte qu'une couche de film composite est formée sur une surface du substrat en verre, dans lequel la cible en alliage comprend deux types d'atomes d'éléments ; et
l'injection de gaz dans la couche de film composite, dans lequel des atomes gazeux ou des ions gazeux d'un plasma gazeux formé par excitation du gaz réagissent avec la couche de film composite, pour obtenir un couvercle en verre avec une surface sur laquelle une couche de film optique est formée, et un indice de réfraction de la couche de film optique est de 1,46 à 1,62, dans lequel la couche de film optique comprend un premier matériau et un deuxième matériau qui sont mélangés au niveau atomique, un rapport de masse du premier matériau au deuxième matériau étant de (1 à 8):1, un indice de réfraction du premier matériau étant > 1,6, et un indice de réfraction du deuxième matériau étant < 1,52, dans lequel le premier matériau comprend au moins un de Si₃N₄, Al₂O₃, AlN, ZrO₂, Nb₂O₅, Ta₂O₅, et TiO₂, dans lequel le deuxième matériau comprend au moins un de SiO₂, MgF₂, LaF₃, et AlF₃, et
dans lequel, pendant le processus au cours duquel la couche de film composite réagit avec le plasma gazeux, une vitesse de rotation du substrat en verre est maintenue à 50 tr/min à 120 tr/min.

8. Dispositif électronique, comprenant le couvercle en verre selon l'une quelconque des revendications 1 à 6 ou un couvercle en verre préparé selon le procédé de préparation d'un couvercle en verre selon la revendication 7.
